# EUROPÄISCHE PATENTANMELDUNG

(11) **EP 4 245 737 A1**
(43) Veröffentlichungstag der Anmeldung: **20.09.2023**
(21) Anmeldenummer: 22162852.2
(22) Anmeldetag: 18.03.2022
(51) Int. Cl.: C04B 28/02, C04B 28/04, C04B 28/06, C04B 28/10, C04B 28/34, C04B 40/00, H01L 23/29

(54) **HYDRAULISCH HÄRTBARE ANORGANISCHE ZEMENTZUSAMMENSETZUNG**

(71) Anmelder: Heraeus Deutschland GmbH & Co. KG, 63450 Hanau (DE)
(72) Erfinder: Scheibel, Markus, 63450 Hanau (DE); Albert, Tamara, 63450 Hanau (DE)

(57) **Zusammenfassung**

Hydraulisch härtbare anorganischen Zementzusammensetzung umfassend mindestens eine Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen und mindestens ein wasserdispergierbares EVA-Copolymer.

## Beschreibung

Die Erfindung betrifft eine hydraulisch härtbare anorganische Zementzusammensetzung, aus der durch Vermischen mit Wasser eine wässrige hydraulisch härtbare anorganische Zementzubereitung hergestellt werden kann. Die wässrige hydraulisch härtbare anorganische Zementzubereitung kann zur Herstellung einer hydraulisch gehärteten anorganischen Zementzusammensetzung insbesondere in Form einer Umhüllung einer elektronischen Komponente verwendet werden.

Der hierin verwendete Begriff "hydraulisches Härten" umfasst ein Abbinden in Gegenwart von Wasser respektive nach Zusatz von Wasser.

Hierin wird unterschieden zwischen hydraulisch härtbarer anorganischer Zementzusammensetzung, wässriger hydraulisch härtbarer anorganischer Zementzubereitung und hydraulisch gehärteter anorganischer Zementzusammensetzung. Aus einer hydraulisch härtbaren anorganischen Zementzusammensetzung kann durch Vermischen mit Wasser eine wässrige hydraulisch härtbare anorganische Zementzubereitung insbesondere in Form einer viskoelastischen, beispielsweise pastösen oder fließfähigen Masse hergestellt werden, auch als "Zementleim (englisch: cement paste oder cement glue)" bezeichnet. Eine wässrige hydraulisch härtbare anorganische Zementzubereitung wiederum kann nach ihrer Applikation zu einer hydraulisch gehärteten anorganischen Zementzusammensetzung in Form eines harten Festkörpers aushärten und trocknen. Besagter harter Festkörper wird auch als "Zementstein (englisch: cement stone)" bezeichnet. Eine derartige hydraulisch gehärtete anorganische Zementzusammensetzung ist praktisch wasserunlöslich, d.h. im Wesentlichen oder vollständig wasserunlöslich.

Der hierin verwendete Begriff "elektronische Komponente" umfasst neben passiven elektronischen Bauteilen insbesondere Halbleitermodule und unter letzteren insbesondere elektronische Baugruppen.

Unter Halbleitermodulen werden hierin elektronische Baugruppen umfassend mindestens ein Substrat (als Schaltungsträger), mindestens einen Halbleiterbaustein (Halbleiter) sowie gegebenenfalls mindestens ein passives elektronisches Bauteil verstanden. Der mindestens eine Halbleiterbaustein kann dabei selber schon teilweise oder vollständig vorumhüllt sein, beispielsweise mit einer Ummantelung auf Epoxidharzbasis.

Hierin wird der Begriff "elektronische Baugruppe" verwendet. Eine elektronische Baugruppe im Sinne der vorliegenden Erfindung umfasst mindestens ein Substrat und mindestens ein damit mechanisch und elektrisch verbundenes elektronisches Bauteil. Die mechanische und elektrische Verbindung kann eine elektrisch leitfähige Lot-, Sinter- und/oder Klebeverbindung sein. Ferner kann eine solche elektronische Baugruppe einer elektrischen Verbindung dienende Elemente wie Bondbändchen, Bonddrähte, Clips, Abstandshalter und/oder Folien umfassen. Beispiele für elektronische Baugruppen in Rahmen- oder rahmenloser Bauweise umfassen diskrete Bauteile wie sogenannte power discretes, Leistungsmodule, Spannungswandler und bestimmte Sensoren.

Beispiele für Substrate umfassen IMS-Substrate (insulated metal-Substrate, isolierte Metallsubstrate), Metallkeramiksubstrate wie z.B. AMB-Substrate (active metal brazed-Substrate) und DCB-Substrate (direct copper bonded-Substrate), Keramiksubstrate, PCBs (printed circuit boards, gedruckte Leiterplatten) und Leadframes.

Elektronische Bauteile können eingeteilt werden in aktive und passive elektronische Bauteile.

Beispiele für aktive elektronische Bauteile umfassen Dioden, LEDs (light emitting diodes, Leuchtdioden), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren).

Beispiele für passive elektronische Bauteile umfassen Bodenplatten, Kühlkörper, Verbindungselemente, Widerstände, Kondensatoren, Induktoren, Antennen Transformatoren, Drosseln, Spulen und keine elektronischen Baugruppen darstellende Sensoren.

Aufgabe der Erfindung war die Bereitstellung einer hydraulisch härtbaren anorganischen Zementzusammensetzung, aus der wässrige Zement-Umhüllungsmassen zur Herstellung von Umhüllungen elektronischer Komponenten hergestellt werden können. Die fertigen Umhüllungen sollen sich auszeichnen durch gute Haftung zu Oberflächen verschiedenster Materialien, wie sie bei elektronischen Komponenten, insbesondere auch zugleich bei einer einzelnen elektronischen Komponente vorhanden sein können. Beispiele für solche verschiedenste Materialoberflächen umfassen Oberflächen aus Keramiken, Kunststoffen, Halbleitern wie Silizium, Siliziumcarbid und Galliumnitrid sowie Metallen wie Kupfer, Silber, Nickel, Gold, Palladium und Aluminium.

Hydraulisch härtbare anorganische Zementzusammensetzungen sind beispielsweise in WO 2015/067441 A1, WO 2015/193035 A1 und WO 2019/025033 A1 offenbart.

Es hat sich gezeigt, dass die Aufgabe gelöst werden kann durch Bereitstellung einer hydraulisch härtbaren anorganischen Zementzusammensetzung umfassend mindestens eine wasserlösliche Verbindung ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen und mindestens ein wasserdispergierbares EVA-Copolymer (Ethylen-Vinylacetat-Copolymer).

Konkret betrifft die Erfindung eine hydraulisch härtbare anorganische Zementzusammensetzung umfassend 0,1 bis 10 Gew.-%, bevorzugt 0,5 bis 3 Gew.-% mindestens einer Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen und 0,1 bis 10 Gew.-%, bevorzugt 0,5 bis 3 Gew.-% mindestens eines wasserdispergierbaren EVA-Copolymeren.

Der Kürze halber wird die "Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen" in der weiteren Folge auch als "Verbindung A" bezeichnet.

Bevorzugt liegt die mindestens eine Verbindung A im Gewichtverhältnis von 0,8 bis 3 zu dem mindestens einen wasserdispergierbaren EVA-Copolymeren vor.

Die erfindungsgemäße als Pulver (in Pulverform) vorliegende hydraulisch härtbare anorganische Zementzusammensetzung kann durch Vermischen mit Wasser in eine wässrige hydraulisch härtbare als Umhüllungsmasse verwendbare Zubereitung überführt werden. Die wässrige Umhüllungsmasse kann zur Herstellung einer hydraulisch gehärteten Umhüllung einer elektronischen Komponente verwendet werden.

Die erfindungsgemäße hydraulisch härtbare anorganischen Zementzusammensetzung umfasst neben besagter mindestens einer Verbindung A und besagtem mindestens einen wasserdispergierbaren EVA-Copolymeren, möglichem partikelförmigem Füllstoff und möglichen weiteren Bestandteilen einen hydraulisch härtbaren anorganischen Zement. Letzterer ist ein Pulver. Die Zementpulverteilchen können beispielsweise absolute Teilchengrößen im Bereich von bis zu 1 mm aufweisen. Es kann sich bei dem hydraulisch härtbaren anorganischen Zement beispielsweise um einen dem Fachmann bekannten Portlandzement, Tonerdezement, Magnesiumoxidzement oder Phosphatzement handeln. Bevorzugt ist ein Phosphatzement, beispielsweise Zinkphosphatzement oder insbesondere Magnesiumphosphatzement. Der hydraulisch härtbare anorganische Zement kann beispielsweise 2 bis 95 Gew.-%, bevorzugt 3 bis 40 Gew.-% der erfindungsgemäßen hydraulisch härtbaren anorganischen Zementzusammensetzung ausmachen.

Die mindestens eine Verbindung A besitzt bevorzugt mindestens eine polare Gruppe, beispielsweise eine ionische oder amphotere Gruppe. Bei dem 5- oder 6-gliedrigen aromatischen stickstoffheterocyclischen und von weiteren Ringheteroatomen freien Ringsystem kann es sich beispielsweise um ein Pyrrol, ein Pyrazol, ein Imidazol, ein Triazol, ein Tetrazol, ein Pyridin, ein Pyrimidin, ein Pyridazin, ein Pyrazin oder ein Triazin handeln. Es kann sich dabei auch um ein anneliertes Ringsystem handeln. Die mindestens eine Verbindung A kann demzufolge ausgewählt sein aus der Gruppe bestehend aus entsprechenden Derivaten von Pyrrol, von Pyrazol, von Imidazol, eines Triazols, von Tetrazol, von Pyridin, von Pyrimidin, von Pyridazin, von Pyrazin oder eines Triazins. Bevorzugt sind Imidazolderivate. Ein besonders bevorzugt in der erfindungsgemäßen hydraulisch härtbaren anorganischen Zementzusammensetzung verwendetes Imidazolderivat ist die Aminosäure Histidin.

Es wird angenommen, dass der aromatische stickstoffheterocyclische Ring der mindestens einen Verbindung A insbesondere haftungsfördernd gegenüber Metalloberflächen wirkt; vermutet wird dabei ein komplexierender Mechanismus gegenüber Metall wie beispielsweise Kupfer, Silber und Aluminium. Die bevorzugt vorhandene mindestens eine polare Gruppe kann einen Beitrag zur Wasserlöslichkeit in der wässrigen hydraulisch härtbaren anorganischen Zementzubereitung leisten. Es wird ferner angenommen, dass sich die bevorzugt vorhandene mindestens eine polare Gruppe in der hydraulisch gehärteten anorganischen Zementzusammensetzung zur eher polaren Zementmatrix hin orientieren kann, während sich die stickstoffheterocyclische Struktur vermutlich komplexierend wirkend zu einer Metalloberfläche hin ausrichten kann.

Besagte wasserdispergierbare EVA-Copolymere können durch Emulsionspolymerisation in wässriger Umgebung ohne Zugabe von organischen Lösungsmitteln gefolgt von einer Sprühtrocknung hergestellt werden. Dabei können insbesondere wasserredispergierbare EVA-Copolymerdispersionspulver erhalten werden. Bevorzugt sind solche wasserredispergierbaren EVA-Copolymerdispersionspulver mit einer Mindestfilmbildetemperatur beispielsweise im Bereich von 0 bis 4 °C. Wasserredispergierbare EVA-Copolymerdispersionspulver sind kommerziell erhältlich; sie werden beispielsweise von Wacker unter der Bezeichnung VINNAPAS^{®} unter anderem als Zusatzstoff für Trockenmörtel angeboten.

Die erfindungsgemäße hydraulisch härtbare anorganische Zementzusammensetzung kann insbesondere aus folgenden Bestandteilen zusammengesetzt sein:
(a) 2 bis 95 Gew.-%, bevorzugt 3 bis 40 Gew.-% eines Zements ausgewählt aus der Gruppe bestehend aus Portlandzement, Tonerdezement, Magnesiumoxidzement und Phosphatzement,
(b) 0,1 bis 10 Gew.-%, bevorzugt 0,5 bis 3 Gew.-% mindestens einer Verbindung A,
(c) 0,1 bis 10 Gew.-%, bevorzugt 0,5 bis 3 Gew.-% mindestens eines wasserdispergierbaren EVA-Copolymeren,
(d) 0 bis 90 Gew.-%, bevorzugt 40 bis 80 Gew.-% mindestens eines partikelförmigen Füllstoffs, und
(e) 0 bis 30 Gew.-%, bevorzugt 2 bis 15 Gew.-% mindestens eines von den Bestandteilen (a) bis (d) verschiedenen Bestandteils. Die Bestandteile (a) bis (e) addieren sich dabei zu 100 Gew.-% erfindungsgemäßer hydraulisch härtbarer anorganischer Zementzusammensetzung; mit anderen Worten, die erfindungsgemäße hydraulisch härtbare anorganische Zementzusammensetzung kann aus den Bestandteilen (a), (b) und (c) oder aus den Bestandteilen (a), (b), (c) und (d) oder aus den Bestandteilen(a), (b), (c) und (e) oder aus den Bestandteilen (a), (b), (c), (d) und (e) bestehen.

Bestandteil (a) ist ein hydraulisch härtbarer anorganischer Zement. Er ist ein Pulver. Die Zementpulverteilchen können beispielsweise absolute Teilchengrößen im Bereich von bis zu 1 mm aufweisen. Der hydraulisch härtbare anorganische Zement ist ausgewählt aus der Gruppe bestehend aus Portlandzement, Tonerdezement, Magnesiumoxidzement und Phosphatzement. Bevorzugt handelt es sich bei Bestandteil (a) um einen Phosphatzement, beispielsweise Zinkphosphatzement oder insbesondere Magnesiumphosphatzement.

Der als Bestandteil (a) insbesondere bevorzugte Phosphatzement kann sich zusammensetzen aus:
(a1) 10 bis 90 Gew.-%, bevorzugt 30 bis 60 Gew.-% mindestens eines Hydrogenphosphats ausgewählt aus der Gruppe bestehend aus Mono- und Dihydrogenphosphaten von Magnesium, Calcium und Aluminium, und
(a2) 90 bis 10 Gew.-%, bevorzugt 70 bis 40 Gew.-% mindestens einer Verbindung ausgewählt aus der Gruppe bestehend aus Oxiden, Hydroxiden und Oxidhydraten von Magnesium, Calcium, Eisen, Zink, Zirkonium, Lanthan und Kupfer. Die Summe der Gewichts-% der Bestandteile (a1) und (a2) ergibt dabei 100 Gew.-% Bestandteil (a).

Bei Bestandteil (a1) handelt es sich um mindestens eine Substanz ausgewählt aus der Gruppe bestehend aus Magnesiummonohydrogenphosphat, Calciummonohydrogenphosphat, Aluminiummonohydrogenphosphat, Magnesiumdihydrogenphosphat, Calciumdihydrogenphosphat und Aluminiumdihydrogenphosphat. Mit anderen Worten, es handelt sich um mindestens ein Hydrogenphosphat ausgewählt aus der Gruppe bestehend aus Mono- und Dihydrogenphosphaten von Magnesium, Calcium, Aluminium. Insbesondere handelt es sich um mindestens ein Hydrogenphosphat ausgewählt aus der Gruppe bestehend aus Mono- und Dihydrogenphosphaten von Magnesium und Aluminium.

Bestandteil (a1) ist ein Pulver mit absoluten Teilchengrößen beispielsweise im Bereich von bis zu 1 mm.

Bei Bestandteil (a2) handelt es sich um mindestens eine Verbindung ausgewählt aus der Gruppe bestehend aus Oxiden, Hydroxiden und Oxidhydraten von Magnesium, Calcium, Eisen, Zink, Zirkonium, Lanthan und Kupfer, insbesondere um mindestens eine Verbindung ausgewählt aus der Gruppe bestehend aus Magnesiumoxid, Magnesiumhydroxid, Zirkoniumoxid, Zirkoniumoxidhydrat und Zirkoniumhydroxid. Magnesiumoxid ist besonders bevorzugt.

Bestandteil (a2) ist ein Pulver beispielsweise mit absoluten Teilchengrößen im Bereich von bis zu 1 mm.

Um unnötige Längen zu vermeiden, wird bezüglich der Bestandteile (b) und (c) auf das Vorerwähnte Bezug genommen.

Beim optionalen, bevorzugt jedoch vorhandenen Bestandteil (d) handelt es sich um mindestens einen partikelförmigen Füllstoff, der insbesondere ausgewählt sein kann aus der Gruppe bestehend aus Mono-, Oligo- und Polyphosphaten von Magnesium, Calcium, Barium und Aluminium; Calciumsulfat; Bariumsulfat; einfachen und komplexen Silikaten umfassend Calcium, Aluminium, Magnesium, Eisen und/oder Zirkonium; einfachen und komplexen Aluminaten umfassend Calcium, Magnesium und/oder Zirkonium; einfachen und komplexen Titanaten umfassend Calcium, Aluminium, Magnesium, Barium und/oder Zirkonium; einfachen und komplexen Zirkonaten umfassend Calcium, Aluminium und/oder Magnesium; Zirkoniumdioxid; Titandioxid; Aluminiumoxid; Siliziumdioxid, insbesondere in Form von Kieselsäure und Quarz; Siliziumcarbid; Aluminiumnitrid; Bornitrid und Siliziumnitrid. Hierin wird zwischen einfachen und komplexen Silikaten, Aluminaten, Titanaten und Zirkonaten unterschieden. Bei den komplexen Vertretern handelt es sich nicht etwa um Komplexverbindungen, vielmehr sind damit Silikate, Aluminate, Titanate und Zirkonate gemeint mit mehr als einer Art von Kationen, wie beispielsweise Calciumaluminiumsilikat, Bleizirkontitanat usw.

Bestandteil (d) ist ein Pulver mit absoluten Teilchengrößen beispielsweise im Bereich von bis zu 1 mm.

Beim optionalen Bestandteil (e) handelt es sich um einen oder mehrere jeweils von den Bestandteilen (a) bis (d) verschiedene Bestandteile wie beispielsweise Fließverbesserer, Abbindeverzögerer (Topfzeitverlängerer), Entschäumer, Hydrophobisierungsmittel, Oberflächenspannung beeinflussende Additive, Benetzungsmittel, Haftvermittler und Fasern. Beispiele für Fasern umfassen Glasfasern, Basaltfasern, Borfasern und keramische Fasern, beispielsweise Siliziumkarbidfasern und Aluminiumoxidfasern, Steinwollfasern, Wollastonitfasern und Aramidfasern.

Die erfindungsgemäße und insbesondere aus den Bestandteilen (a), (b), (c), bevorzugt auch (d) und gegebenenfalls (e) bestehende hydraulisch härtbare anorganische Zementzusammensetzung kann als einkomponentige pulverförmige Zusammensetzung oder in Form zweier oder mehrerer jeweils pulverförmiger Komponenten, d.h. voneinander verschiedener und separater Komponenten (separat zu lagernder bzw. separat gelagerter Komponenten) vorliegen. Im Falle einer zwei- oder mehrkomponentigen Zusammensetzung, umfassen die Komponenten zusammen alle Bestandteile, d.h. im Besonderen die Bestandteile (a), (b) und (c); respektive (a) bis (d); (a) bis (e); oder (a), (b), (c) und (e). Die zwei oder mehreren Komponenten werden separat voneinander gelagert bis zu ihrer Verwendung zur Herstellung einer wässrigen hydraulisch härtbaren anorganischen Zementzubereitung; dabei kann es insbesondere zweckmäßig sein, eine zumindest im Wesentlichen voneinander separate Lagerung von Bestandteilen (a1) und (a2) zu verwirklichen.

Aus einer erfindungsgemäßen hydraulisch härtbaren anorganischen Zementzusammensetzung, welche in ein-, zwei- oder mehrkomponentiger Pulverform vorliegen kann, kann durch Vermischen mit Wasser eine wässrige hydraulisch härtbare anorganische Zementzubereitung hergestellt werden. Im Falle eines Zwei- oder Mehrkomponentensystems können zunächst die Komponenten zu einer einkomponentigen hydraulisch härtbaren anorganischen Zementzusammensetzung vermischt und diese dann mit Wasser vermischt werden. Es ist aber auch möglich nur eine, einige oder alle Komponenten zunächst mit Wasser zu vermischen, beispielsweise zu Pasten; danach kann ein weiteres Vermischen unter Bildung der wässrigen hydraulisch härtbaren anorganischen Zementzubereitung erfolgen. Eine derartige wässrige hydraulisch härtbare anorganische Zementzubereitung kann zur Herstellung einer hydraulisch gehärteten anorganischen Zementzusammensetzung insbesondere in Form einer Umhüllung einer elektronischen Komponente verwendet werden; sie kann nach ihrer Applikation hydraulisch zu einer hydraulisch gehärteten anorganischen Zementzusammensetzung in Form eines harten Festkörpers aushärten und trocknen. Besagter harter Festkörper kann insbesondere besagte Umhüllung einer elektronischen Komponente sein.

Eine aus einer erfindungsgemäßen hydraulisch härtbaren anorganischen Zementzusammensetzung durch Vermischen mit Wasser erhältliche wässrige hydraulisch härtbare anorganische Zementzubereitung kann einen Wasseranteil von beispielsweise 6 bis 25 Gew.-% aufweisen.

Die Viskosität einer frisch hergestellten (innerhalb von 5 Minuten nach Fertigstellung) wässrigen hydraulisch härtbaren anorganischen Zementzubereitung kann beispielsweise im Bereich von 0,5 bis 20 Pa·s (bei Bestimmung mittels Rotationsviskosimetrie, Platte-Platte-Messprinzip, Plattendurchmesser 25 mm, Messspalt 1 mm, Probentemperatur 20°C) liegen.

Wie gesagt, die wässrige hydraulisch härtbare anorganische Zementzubereitung kann als wässrige Umhüllungsmasse für elektronische Komponenten verwendet werden. Der Kürze halber wird in der weiteren Folge auch der Begriff "wässrige Umhüllungsmasse" anstelle von "wässrige hydraulisch härtbare anorganische Zementzubereitung" verwendet.

Die wässrige Umhüllungsmasse kann zur Herstellung einer hydraulisch gehärteten Umhüllung von elektronischen Komponenten verwendet werden. Das Herstellungsverfahren umfasst die Schritte:
(1) Bereitstellen einer zu umhüllenden elektronischen Komponente,
(2) Bereitstellen einer durch Vermischen einer erfindungsgemäßen hydraulisch härtbaren anorganischen Zementzusammensetzung mit Wasser hergestellten wässrigen Umhüllungsmasse,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.

In Schritt (1) wird eine zu umhüllende elektronische Komponente bereitgestellt. Bezüglich des Begriffs "elektronische Komponente" wird auf das Vorerwähnte verwiesen.

Bezüglich Schritt (2) wird auf das Vorerwähnte verwiesen.

Bevorzugt wird Schritt (3) unverzüglich, beispielsweise innerhalb von 60 Minuten, bevorzugt innerhalb von 10 Minuten nach Beendigung von Schritt (2) respektive nach Beendigung der Herstellung der wässrigen Umhüllungsmasse durchgeführt.

In Schritt (3) erfolgt das Umhüllen der in Schritt (1) bereitgestellten elektronischen Komponente mit der gemäß Schritt (2) bereitgestellten wässrigen Umhüllungsmasse. Bevorzugte Applikationsmethoden sind Vergießen, Tauchen und Spritzgießen (englisch: transfer molding). Das Vergießen kann mittels üblichen, dem Fachmann bekannten Methoden erfolgen, beispielsweise durch Schwerkraft-, vakuum- oder druckunterstützten Verguss (englisch: compression molding). Dabei kann es zweckmäßig sein, die zu umhüllende elektronische Komponente mit Halbschalenformen zu umschließen und dann mit der wässrigen Umhüllungsmasse zu füllen. Das Umhüllen kann als teilweises oder vollständiges Umhüllen erfolgen. Beispielsweise kann bei der Umhüllung eines Halbleitermoduls so gearbeitet werden, dass die Umhüllungsmasse mit dem Halbleiterbaustein verbundene elektrische Kontaktierungselemente wie beispielsweise Bonddrähte, Bändchen und/oder ein Substrat teilweise oder vollständig umhüllt. Teilweise Umhüllung bedeutet dabei, dass ein oder mehrere der Kontaktierungselemente unvollständig und/oder ein oder mehrere der Kontaktierungselemente nicht umhüllt sind, während vollständige Umhüllung bedeutet, dass alle Kontaktierungselemente vollständig umhüllt sind. Das Vergießen kann aber beispielsweise auch so erfolgen, dass die Umhüllungsmasse als dem Fachmann bekanntes "glob-top" ausgebildet wird.

Im auf Schritt (3) folgenden Schritt (4) wird die wässrige, die elektronische Komponente umhüllende Umhüllungsmasse hydraulisch gehärtet. Selbstverständlich beginnt das hydraulische Härten schon ab dem Moment, in dem die wässrige Umhüllungsmasse hergestellt worden ist, d.h. schon im Zuge von respektive nach Abschluss von Schritt (2).

Das hydraulische Härten kann bei Umgebungsbedingungen, beispielsweise bei einer Umgebungstemperatur im Bereich von 20 bis 25 °C stattfinden und dabei beispielsweise eine Dauer von 1 Minute bis 6 Stunden benötigen. Soll die Dauer verkürzt werden, kann bei erhöhter Temperatur gearbeitet werden, beispielsweise kann das hydraulische Härten bei 30 bis unter 100 °C Objekttemperatur stattfinden und es ist dann schon beispielsweise innerhalb weniger Sekunden bis 2 Stunden beendet.

Ans hydraulische Härten schließt sich zweckmäßig ein Trocknen der Umhüllung an im Sinne einer Entfernung von chemisch nicht gebundenem Wasser aus der hydraulisch gehärteten anorganischen Zementzusammensetzung. Dies kann im weiteren zeitlichen Verlauf geschehen; zweckmäßig allerdings kann auch ein der Entwässerung dienendes forciertes Trocknen ans hydraulische Härten angeschlossen werden, beispielsweise für 0,5 bis 6 Stunden bei 80 bis 200 °C Objekttemperatur; dabei kann es zweckmäßig sein, mehrere Temperaturstufen zu durchlaufen. Das Trocknen kann vakuumunterstützt erfolgen.

### Vergleichsbeispiele V1 bis V3 und erfindungsgemäße Beispiele 1 bis 4:

7 Gewichtsteile Magnesiumoxidpulver, 2 Gewichtsteile Magnesiumdihydrogenphosphatpulver und 76 Gewichtsteile Zirkoniumsilikatpulver mit einer maximalen Teilchengröße von 100 µm wurden zu einer hydraulisch härtbaren anorganischen Magnesiumphosphatzementzusammensetzung vorvermischt. Die Vormischung wurde anschließend gemäß der Gewichtsteile in Tabelle 1 mit Histidin, einem wasserredispergierbaren EVA-Copolymerdispersionspulver (VINNAPAS^{®} 5044N von Wacker) und Wasser zu wässrigen hydraulisch härtbaren Magnesiumphosphatzementzubereitungen vermischt.

**Tabelle 1:**

| Beispiel | Vormischung (Gew.-%) | Histidin (Gew.-%) | EVA-Copolymer (Gew.-%) | Gewichtsverhältnis Histidin: EVA-Copolymer | Wasser (Gew.-%) |
|---|---|---|---|---|---|
| V1 | 85 | 0 | 1,16 | - | 13,84 |
| V2 | 85 | 2,12 | 0 | - | 12,88 |
| V3 | 85 | 0 | 0 | - | 15,00 |
| 1 | 85 | 1,16 | 1,16 | 1,00 | 12,68 |
| 2 | 85 | 0,34 | 2,01 | 0,17 | 12,65 |
| 3 | 85 | 0,75 | 1,50 | 0,50 | 12,75 |
| 4 | 85 | 2,12 | 0,42 | 5,00 | 12,46 |

Die Haftung der aus den wässrigen hydraulisch härtbaren Magnesiumphosphatzementzubereitungen nach Applikation und hydraulischer Härtung auf Kupfer- und Aluminiumoxid-Oberflächen wurde wie folgt bestimmt:
Auf ebene Kupfer- bzw. Aluminiumoxidkeramikplatten wurden Silikonmasken mit sechs quadratischen Aussparungen von je 5x5 cm gelegt. In die Aussparungen wurde die jeweilige wässrige hydraulisch härtbare Magnesiumphosphatzementzubereitung mit Hilfe einer Spritze bis zu einer Füllhöhe von 3 mm eingefüllt. Anschließend wurde die Zementzubereitung bei 20°C für 2 Stunden hydraulisch ausgehärtet. Die Silikonmasken wurden danach entfernt und die mit den hydraulisch gehärteten quadratischen Zementproben versehenen Kupfer- bzw. Aluminiumoxidkeramikplatten wurden in einem Laborofen behandelt; hierzu wurde die Ofentemperatur mit einer Heizrate von 1°C/min ausgehend von 20°C auf 90°C erhöht und für 1 Stunde auf 90°C gehalten. Anschließend wurde die Ofentemperatur mit einer Heizrate von 1°C/min auf 160°C erhöht und für 1 Stunde auf 160°C gehalten. Danach wurde mit einer Abkühlrate von 1°C/min auf 20°C abgekühlt. Danach wurde die Scherfestigkeit als Sechsfachbestimmung mit dem Messgerät DAGE 2000 der Firma Dage (Deutschland) bestimmt. Die Zementproben wurden mit einem Schermeißel von 6 mm Kantenlänge auf einer Scherhöhe von 2/3 der Probenhöhe unter Einhaltung einer Schergeschwindigkeit von 300 µm/s geschert. Zur Verbesserung der Messgenauigkeit wurde die Scherkraft der 100 kg-Messdose auf 20 kg heruntergesetzt. Tabelle 2 zeigt die erhaltenen Messergebnisse.

**Tabelle 2:**

| Beispiel | Haftung auf Kupfer (MPa) | Haftung auf Aluminiumoxid (MPa) |
|---|---|---|
| V1 | 0 (keine Haftung) | 0,6 |
| V2 | 1,0 | 0 (keine Haftung) |
| V3 | 0 (keine Haftung) | 0 (keine Haftung) |
| 1 | 2,5 | 1,4 |
| 2 | 0,3 | 0,1 |
| 3 | 1,4 | 0,3 |
| 4 | 1,1 | 0,1 |

## Patentansprüche

1. Hydraulisch härtbare anorganische Zementzusammensetzung umfassend mindestens eine wasserlösliche Verbindung ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen und mindestens ein wasserdispergierbares EVA-Copolymer.

2. Hydraulisch härtbare anorganische Zementzusammensetzung nach Anspruch 1, umfassend 0,1 bis 10 Gew.-% mindestens einer Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen und 0,1 bis 10 Gew.-% mindestens eines wasserdispergierbaren EVA-Copolymeren.

3. Hydraulisch härtbare anorganische Zementzusammensetzung nach Anspruch 2, wobei die mindestens eine Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen im Gewichtverhältnis von 0,8 bis 3 zu dem mindestens einen wasserdispergierbaren EVA-Copolymeren vorliegt.

4. Hydraulisch härtbare anorganische Zementzusammensetzung nach Anspruch 2 oder 3, umfassend einen hydraulisch härtbaren anorganischen Zement neben der mindestens einen Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen, dem mindestens einen wasserdispergierbaren EVA-Copolymeren, möglichem partikelförmigem Füllstoff und möglichen weiteren Bestandteilen.

5. Hydraulisch härtbare anorganische Zementzusammensetzung nach Anspruch 4, wobei der hydraulisch härtbare anorganische Zement ein Portlandzement, Tonerdezement, Magnesiumoxidzement oder Phosphatzement ist.

6. Hydraulisch härtbare anorganische Zementzusammensetzung nach Anspruch 4 oder 5, wobei der hydraulisch härtbare anorganische Zement 2 bis 95 Gew.-% der hydraulisch härtbaren anorganischen Zementzusammensetzung ausmacht.

7. Hydraulisch härtbare anorganische Zementzusammensetzung zusammengesetzt aus:
(a) 2 bis 95 Gew.-% eines Zements ausgewählt aus der Gruppe bestehend aus Portlandzement, Tonerdezement, Magnesiumoxidzement und Phosphatzement,
(b) 0,1 bis 10 Gew.-% mindestens einer Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen,
(c) 0,1 bis 10 Gew.-% mindestens eines wasserdispergierbaren EVA-Copolymeren,
(d) 0 bis 90 Gew.-% mindestens eines partikelförmigen Füllstoffs, und
(e) 0 bis 30 Gew.-% mindestens eines von den Bestandteilen (a) bis (d) verschiedenen Bestandteils,
wobei sich die Bestandteile (a) bis (e) zu 100 Gew.-% addieren.

8. Hydraulisch härtbare anorganische Zementzusammensetzung nach Anspruch 7, wobei Bestandteil (a) ein Phosphatzement ist, zusammengesetzt aus:
(a1) 10 bis 90 Gew.-% mindestens eines Hydrogenphosphats ausgewählt aus der Gruppe bestehend aus Mono- und Dihydrogenphosphaten von Magnesium, Calcium und Aluminium, und
(a2) 90 bis 10 Gew.-% mindestens einer Verbindung ausgewählt aus der Gruppe bestehend aus Oxiden, Hydroxiden und Oxidhydraten von Magnesium, Calcium, Eisen, Zink, Zirkonium, Lanthan und Kupfer,
wobei die Summe der Gewichts-% der Bestandteile (a1) und (a2) 100 Gew.-% ergibt.

9. Hydraulisch härtbare anorganische Zementzusammensetzung nach einem der Ansprüche 2 bis 8, wobei die mindestens eine Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen ausgewählt ist aus der Gruppe bestehend aus Derivaten von Pyrrol, von Pyrazol, von Imidazol, eines Triazols, von Tetrazol, von Pyridin, von Pyrimidin, von Pyridazin, von Pyrazin oder eines Triazins.

10. Hydraulisch härtbare anorganische Zementzusammensetzung nach Anspruch 9, wobei die mindestens eine Verbindung mit einer Wasserlöslichkeit >10 g/L (bei 20°C) ausgewählt aus der Gruppe bestehend aus 5-gliedrigen ein aromatisches stickstoffheterocyclisches und von weiteren Ringheteroatomen freies Ringsystem aufweisenden Verbindungen und 6-gliedrigen ein aromatisches stickstoffheterocyclisches und von weiteren Ringheteroatomen freies Ringsystem aufweisenden Verbindungen ein Imidazolderivat ist.

11. Hydraulisch härtbare anorganische Zementzusammensetzung nach einem der vorhergehenden Ansprüche als einkomponentige pulverförmige Zusammensetzung oder in Form zweier oder mehrerer jeweils pulverförmiger voneinander verschiedener und separater Komponenten.

12. Wässrige hydraulisch härtbare anorganische Zementzubereitung hergestellt durch Vermischen einer hydraulisch härtbaren anorganischen Zementzusammensetzung nach einem der vorhergehenden Ansprüche mit Wasser.

13. Verwendung einer wässrigen hydraulisch härtbaren anorganischen Zementzubereitung nach Anspruch 12 zur Herstellung einer hydraulisch gehärteten anorganischen Zementzusammensetzung in Form einer Umhüllung einer elektronischen Komponente.

14. Verfahren zur Herstellung einer hydraulisch gehärteten Umhüllung einer elektronischen Komponente, umfassend die Schritte:
(1) Bereitstellen einer zu umhüllenden elektronischen Komponente,
(2) Bereitstellen einer durch Vermischen einer hydraulisch härtbaren anorganischen Zementzusammensetzung nach einem der Ansprüche 1 bis 11 mit Wasser hergestellten wässrigen Umhüllungsmasse,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.
